# EUROPEAN PATENT SPECIFICATION

(11) **EP 2 659 588 B1**
(45) Date of publication and mention of the grant of the patent: **23.11.2016**
(21) Application number: 11802012.2
(22) Date of filing: 06.12.2011
(51) Int. Cl.: H03K 17/722, H03K 17/79, H03K 17/725, H02J 9/00

(54) **A CONTROL UNIT USED IN HOUSEHOLD APPLIANCES**
STEUEREINHEIT FÜR HAUSHALTSGERÄTE
UNITÉ DE COMMANDE UTILISÉE DANS DES APPAREILS ÉLECTROMÉNAGERS

(30) Priority: 27.12.2010 TR 201010960
(43) Date of publication of application: 06.11.2013
(73) Proprietor: Arçelik Anonim Sirketi, 34950 Istanbul (TR)
(72) Inventor: YILDIRIM, Yusuf, 34950 Istanbul (TR); ELMAS, Serdal, 34950 Istanbul (TR); YILDIZ, Gokhan, 34950 Istanbul (TR)
(86) International application number: PCT/EP2011/071855
(87) International publication number: WO 2012/089446

(56) References cited:
- EP-A1- 1 137 151
- EP-A1- 1 978 618
- EP-A1- 2 219 282
- WO-A1-2008/119997
- US-A1- 2004 222 824

## Description

The present invention relates to a control unit that provides the standby power consumed by the household appliances to be decreased.

In electronic household appliances the standby power is defined as the power consumed by the household appliance in stand-by mode or the off mode. In the stand-by mode, the screen that informs the user and the soft on/off button are provided to be kept in active mode. The power control unit disposed in the control circuit of the household appliance consumes energy continuously for keeping the screen or the soft on/off button in active mode. The power consumed by the power control unit for reactivation of the household appliance when desired is defined as the standby power. Decreasing energy consumption of household appliances is gradually becoming important and therefore limitations are set for the standby power.

In state of the art, in the household appliances that operate with the alternative current (AC) supplied from the mains power supply, the touch-operated or soft on/off button is widely used which performs the opening/closing function, and switches the electric current that is of much lower value than the mains current. The on/off button switching the low value current provides ease of utilization and safety. A power source unit that generates low voltage direct current (DC) and which is of switch mode (SMPS), capacitive or resistive type is provided in the electronic control system of the household appliance. The power source unit also generates the power necessary for operating the electronic elements like the microprocessor, relay, semi-conductive switch included in the electronic control system of the household appliance besides the on/off switch. The power source unit has to be supplied with the mains current in order to keep the on/off switch in active mode and this increases energy consumption in the standby mode.

In the state of the art European Patent Application No. EP1511359, a circuit arrangement used in household electrical appliances is explained, comprising a switching device which is provided to keep waiting in standby mode with a low static electric current by means of a comparator when the household appliance is turned off.

The document US 2004/222824 discloses a control unit according to the preamble of claim 1.

The aim of the present invention is the realization of a control unit that provides the standby power consumed by the household appliances to be decreased.

The control unit realized in order to attain the aim of the present invention and explicated in the first claim and the respective claims thereof, comprises a power source unit, known as Switch Mode Power Supply, capacitive power unit or transformer power unit, that converts the electric current received from the mains power supply to low value electric currents for operating electronic elements and a soft push button that switches the low ampere electric current in the switching circuit providing the household appliance to be changed to on mode.

A triac is connected to the power line that transmits the electric current received from the mains to the power source unit by means of the main input output terminals (A1, A2) and the triac receives the signal required for the household appliance changing to the on mode from the switching circuit that the button turns on and off by means of the gate terminal (G).

Resistors are disposed in the switching line, that provide signals with the required electrical value for actuating the triac to be generating.

When the user pushes the button for operating the household appliance, the switching line provides the triac to conduct electric current and to energize the power source unit by actuating the triac from the gate terminal whereto it is connected and when the user pulls his/her hand from the button, the power source unit takes over the function of the switching line which has changed to passive mode and provides the household appliance to continue operating.

The control unit furthermore comprises a feedback line that is disposed between the triac and the microprocessor, supplied by the power source unit and that provides the power source unit hence the household appliance to be kept operational when the user pulls his/her hand from the button, by continuing to actuate the triac.

The household appliance wherein the control unit of the present invention is used, waits in standby mode while connected to the mains voltage and not in use. When the household appliance is in standby mode, the triac does not conduct the mains current to the power source unit unless actuated by the button and leaves the power source unit without energy. Thus, the household appliance is provided not to consume energy if it does not have mains power supply filter in the standby mode, or to consume minimum amount of energy if it has mains power supply filter. The power source unit starts to consume energy only at the moment the button is activated for operating the household appliance by actuating the triac.

The control unit of the present invention can be used in household appliances like the washing machine, laundry dryer, dishwasher or cooking device that are desired to decrease energy consumption in the standby mode.

In an embodiment of the present invention, an optic isolator is disposed in the feedback line in the control unit, that provides the feedback signal to be transmitted to the triac controllably and the triac to be actuated by being energized with the feedback signal sent from the power control port of the microprocessor.

In another embodiment of the present invention, the household appliance wherein the control unit is used is of self-closing type, closing at the end of the defined time when the implemented washing, drying or cooking program is completed, and the start button has only the function of bringing the household appliance to the on mode and does not have the function of bringing the household appliance to the off mode. In this embodiment, the microprocessor cuts off the actuation signals transmitted to the triac a certain time after the program implemented in the household appliance ends, deactivating the triac and the power source unit, providing the household appliance to change to the off mode. The microprocessor provides the user to be alerted with buzzer or LED warning methods when the program implemented in the household appliance ends and changes the household appliance to the off mode by cutting off the signals transmitted to the triac at the end of the defined period, after a certain time recorded in its memory unless the user intervenes.

The button providing the household appliance, waiting in standby mode, to be changed to the on mode is ready to function at any time and the power source unit does not have to be kept in energized mode constantly for the button to function, electric current is not transmitted to the power source unit from the triac the actuation signal of which is cut off even though the household appliance is plugged to the mains current and consequently the household appliance is provided to keep waiting in the standby mode without consuming energy or by consuming a very small amount of energy.

The control unit realized in order to attain the aim of the present invention is illustrated in the attached figures, where:

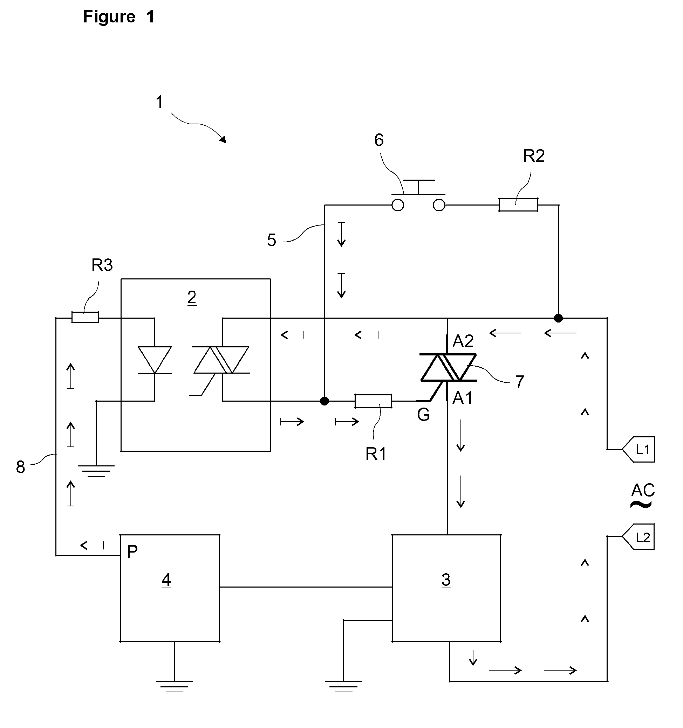

Figure 1 - is the schematic view of a control unit.

The elements illustrated in the figures are numbered as follows:
1. Control unit
2. Optical isolator
3. Power source unit
4. Microprocessor
5. Switching line
6. Button
7. Triac
8. Feedback line

The control unit (1) used in electronic household appliances for decreasing standby power, comprises a power source unit (3) connected to the power line (L1, L2) transmitting the AC electric current received from the mains, of switch mode (SMPS - Switch Mode Power Supply), capacitive or resistive type, generating low voltage DC feed currents, providing the electronic elements to be energized by being supplied with the mains current, a microprocessor (4) wherein the software regulating operation of household appliance and the programs to be implemented are installed and fed with the low voltage current generated by the power source unit (3), a switching line (5) that controls the milliampere scale current passing therethrough for the switching function, a soft type button (6) that switches the low value current passing through the switching line (5), being activated when pressed on by the user, providing the switching line (5) to supply electric current and changing the household appliance to the on mode, providing the current passing through the switching line (5) to be cut off by shifting to passive mode when the user takes off his/her hand while the on mode of the household appliance continues.

The control circuit (1) of the present invention comprises,
- a triac (7) connected to the power line (L1, L2) by means of its main terminals (A1, A2), controlling and transmitting the electric current received from the mains to the power source unit (3),
- the switching line (5) one end of which is connected to the power line (L1, L2), the other end to the gate terminal (G) of the triac (7), having one or more than one resistor (R1, R2) thereon which drops the mains current to the current value required for actuating the triac (7), actuating the triac (7) when the button (6) is activated and providing the triac (7) to energize the power source unit (3) and
- a feedback line (8) that transmits the feedback signals transmitted by the microprocessor (4), which is energized by the power source unit (3), by means of the power control port (P) to the gate terminal (G) of the triac (7) and continues to actuate the triac (7) when the actuation signals transmitted to the gate terminal (G) of the triac (7) by the switching line (5) are cut off by changing the button (6) to the passive mode.

The feedback line (8) provides the household appliance to remain in the on mode, without changing to off mode when the user activates the button (6) by pressing thereon for operating the household appliance, lifting her hand after a short while and bringing the button (6) to the off mode.

When the household appliance is desired to be operated, the user presses on the button (6) and provides the switching line (5) to transmit actuation signals to the triac (7) through the resistors (R1, R2). Currents starts flowing through the triac (7) at the moment it is actuated with the button (6). The power source unit (3) is energized with the current supplied by the triac (7) and provides the microprocessor (4) and the other electronic elements to be fed with low voltage direct current (DC). When the user lifts his/her hand from the button (6), the button (6) shifts to passive mode and the switching line (5) becomes open circuit, not transmitting electric current. The triac (7) should continue to supply current so that the household appliance is not turned off the moment the user lifts his/her hand from the button (6). Since actuation signal is not transmitted from the switching line (5) to the triac (7) in the passive mode of the button (6), the power source unit (3) takes over the function of actuating the triac (7). The power source unit (3) feeds the microprocessor (4) with the current transmitted from the triac (7), which is actuated by the button (6), and the feedback signals generated by the microprocessor (4) actuates the triac (7) through the power control port (P) and the feedback line (8), providing the triac (7) to supply current also in the passive mode of the button (6) and to feed the power source unit (3), keeping the household appliance in the on mode. In other words, at the first moment the button (6) is pressed on, the button (6) provides the power source unit (3) to be energized by actuating the triac (7), after the power source unit (3) is energized once, the button (6) shifts to passive mode, not actuating the triac (7) and the power source unit (3) actuates the triac (7) through the feedback line (8) for continuing the current that feeds itself.

The household appliance wherein the control unit (1) is used remains in the standby mode when connected to the mains current and not in operation, unless the button (6) is pressed on. When the household appliance is in standby mode, the triac (7) does not transmit the mains current to the power source unit (3) since it is not actuated by the button (6) and the switching line (5), providing the power source unit (3) to be kept waiting in deenergized mode. Thus, the household appliance is provided not to consume energy in standby mode or to consume minimum amount of energy. The power source unit (3) starts to consume energy only at the moment the button (6) is shifted to active mode for operating the household appliance as the triac (7) is actuated. The button (6) safely operates the household appliance by switching the milliampere scale electric current in the switching line (5). In order to give the initial operating signal by means of the button (6), receiving energy from the power source unit (3) is not required, the power source unit (3) is kept in passive mode when the household appliance is not in use. Since the power source unit (3) is deactivated when the household appliance is not in use, the household appliance does not consume energy in standby mode or consumes minimum amount of energy if mains filter is used.

In an embodiment of the present invention, the control unit (1) comprises an optic isolator (2), disposed in the feedback line (8), energized with the feedback signal transmitted from the power control port (P) of the microprocessor (4) and providing the feedback signal to be controllably sent to the gate terminal (G) of the triac (7), and providing safety by preventing the electronic elements from being affected with the high value electric current supplied by the mains and driven through a resistor (R3) disposed on the feedback line (8). When the button (6) is shifted to active mode, the power source unit (3) operated by means of the triac (7) energizes the microprocessor (4) and when the button is shifted to passive mode the feedback signals sent from the power control port (P) of the microprocessor (4) are transmitted to the gate terminal (G) of the triac (7) through the optic isolator (2).

In another embodiment of the present invention, the household appliance (1) wherein the control unit (1) is used, is a washing machine.

In another embodiment of the present invention, the household appliance wherein the control unit (1) is used, is a laundry dryer.

In another embodiment of the present invention, the household appliance wherein the control unit (1) is used, is a dishwasher.

In another embodiment of the present invention, the household appliance wherein the control unit (1) is used, is a cooking device.

In another embodiment of the present invention, the household appliance wherein the control unit (1) is used, is self-closing type, closing at the end of the implemented washing, drying, cooking etc programs. In this embodiment, the button (6) has only the function of changing the household appliance to on mode when shifted to active mode and does not have the function of changing the household appliance to off mode.

In this embodiment, the control unit (1) furthermore comprises the microprocessor (4), that provides the triac (7) to be actuated through the optic isolator (2) as long as the program implemented in the household appliance wherein it is used continues, providing the signals that are transmitted from the power control port (P) to the optic isolator (2) and that actuate the triac (7) a certain time after the program implemented in the household appliance ends to be cut off. The microprocessor (4) provides the power source unit (3) to be de-energized and the household appliance to be changed to the off mode by deactivating the triac (7) a certain time after the program implemented in the household appliance ends.

In another embodiment of the present invention, the microprocessor (4) provides the user to be alerted by buzzer and/or LED warning systems when the program implemented in the household appliance ends and before the household appliance is changed to the off mode. If the user does not start a new program, the microprocessor (4) shuts down the household appliance by cutting off the signals transmitted to the triac (7) at the end of a time period predefined in its software.

When the program implemented in the household appliance ends, in the standby mode wherein it changes to the off position, the power source unit (3) is not required to be kept ready for the button (6) to be ready (awake) for functioning at any time, since the power source unit (3) does not consume energy, being isolated from the mains by means of the triac (7), even though the control unit (1) is connected to the mains. The household appliance wherein the control unit (1) is used, is provided to be kept waiting in standby mode with zero energy consumption or with minimum energy consumption.

It is to be understood that the present invention is not limited by the embodiments disclosed above and a person skilled in the art can easily introduce different embodiments. These should be considered within the scope of the protection postulated by the claims of the present invention.

## Claims

1. A control unit (1) suitable for use in household appliance, comprising a power source unit (3) connected to the power line (L1, L2) supplying AC electric current received from the mains, providing the electronic elements to be energized, a microprocessor (4) fed with the low voltage current generated by the power source unit (3), a switching line (5) that controls the milliampere scale current passing therethrough for the switching function, a button (6) that switches the low value current passing through the switching line (5), providing the switching line (5) to supply electric current and change the household appliance to the on mode when pressed on by the user, providing the current passing through the switching line (5) to be cut off while the on mode of the household appliance continues when the user lifts his/her hand, further comprising
- a triac (7) connected to the power line (L1, L2) by means of its main terminals (A1, A2), controlling and transmitting the electric current received from the mains to the power source unit (3),
- the switching line (5) one end of which is connected to the power line (L1, L2), the other end to the gate terminal (G) of the triac (7), actuating the triac (7) when the button (6) is pressed on by the user, by transmitting electric current and providing the triac (7) to energize the power source unit (3) and **characterized by**
- a feedback line (8) that transmits the feedback signals transmitted by the microprocessor (4), energized by the power source unit (3), to the gate terminal (G) of the triac (7) and continues to actuate the triac (7) when the actuation signals transmitted to the triac (7) by the switching line (5) are cut off by the user lifting his/her hand from the button (6).

2. A control unit (1) as in Claim 1, **characterized by** the switching line (5) having one or more than one resistor (R1, R2) thereon which drops the mains current to the current value required for actuating the triac (7).

3. A control unit (1) as in Claim 1 or 2, **characterized by** an optic isolator (2), disposed in the feedback line (8), providing the feedback signal transmitted from the microprocessor (4) to be sent to the gate terminal (G) of the triac (7).

4. A control unit (1) as in Claim 3, **characterized by** an optic isolator (2), driven through a resistor (R3) disposed in the feedback line (8).

5. A control unit (1) as in any one of the above Claims, **characterized by** the microprocessor (4), that provides the triac (7) to be actuated as long as the program implemented in the household appliance continues, providing the signals that actuate the triac (7) to be cut off a certain time after the program implemented in the household appliance ends and changing the household appliance to the off mode after a certain time period predefined in its software.

6. A control unit (1) as in Claim 5, **characterized by** the microprocessor (4) that provides the user to be alerted by buzzer and/or LED warning systems when the program implemented in the household appliance ends and before the household appliance is changed to the off mode.

7. A washing machine **characterized by** a control unit (1) as in any one of the above Claims.

8. A laundry dryer **characterized by** a control unit (1) as in any one of the Claims 1 to 6.

9. A dishwasher **characterized by** a control unit (1) as in any one of the Claims 1 to 6.

10. A cooking device **characterized by** a control unit (1) as in any one of the Claims 1 to 6.

## Patentansprüche

1. Steuereinheit (1), die zur Verwendung in einem Haushaltsgerät geeignet ist, umfassend eine Stromquelleneinheit (3), die mit der Stromleitung (L1, L2) verbunden ist, die elektrischen Wechselstrom vom Stromnetz zuführen und dafür sorgen, dass die elektronischen Elemente mit Strom versorgt werden, einen Mikroprozessor (4), dem der von der Stromquelleneinheit (3) erzeugte Niederspannungsstrom zugeführt wird, eine Schaltleitung (5), die den durch sie fließenden Strom im Milliamperebreich für eine Schaltfunktion steuert, eine Taste (6), die den durch die Schaltleitung (5) fließenden niedrigen Strom schaltet und dafür sorgt, dass die Schaltleitung (5) elektrischen Strom zuführt und das Haushaltsgerät in den Einschaltmodus umschaltet, wenn er von dem Benutzer gedrückt wird, und dafür sorgt, dass der Strom, der durch die Schaltleitung (5) fließt, unterbrochen wird, während der Einschaltmodus des Haushaltsgeräts fortgesetzt wird, wenn der Benutzer seine Hand abhebt,
ferner umfassend
- ein Triac (7), das mittels seiner Hauptkleinen (A1, A2) mit der Stromleitung (L1, L2) verbunden ist und den elektrischen Strom vom Stromnetz an die Stromquelleneinheit (3) steuert und überträgt,
- die Schaltleitung (5), deren eines Ende mit der Stromleitung (L1, L2) und deren anderes Ende mit der Gate-Klemme (G) des Triacs (7) verbunden ist und die das Triac (7) aktiviert, wenn die Taste (6) vom Benutzer gedrückt wird, indem sie elektrischen Strom überträgt, und dafür sorgt, dass das Triac (7) die Stromquelleneinheit (3) mit Strom versorgt, und
**gekennzeichnet durch**
- eine Rückkopplungsleitung (8), die die Rückkopplungssignale, die vom Mikroprozessor (4) übertragen werden, der **durch** die Stromquelleneinheit (3) mit Strom versorgt wird, an die Gate-Klemme (G) des Triacs (7) überträgt und das Triac (7) weiterhin aktiviert, wenn die Aktivierungssignale, die von der Schaltleitung (5) an das Triac (7) übertragen werden, unterbrochen werden, indem der Benutzer seine Hand (6) von der Taste abhebt.

2. Steuereinheit (1) nach Anspruch 1, **dadurch gekennzeichnet, dass** die Schaltleitung (5) einen oder mehrere Widerstände (R1, R2) daran aufweist, die den Netzstrom auf den Stromwert absenken, der zum Aktivieren des Triacs (7) erforderlich ist.

3. Steuereinheit (1) nach Anspruch 1 oder 2, **gekennzeichnet durch** einen optischen Isolator (2), der an der Rückkopplungsleitung (8) angeordnet ist und dafür sorgt, dass das vom Mikroprozessor (4) übertragene Rückkopplungssignal an die Gate-Klemme (G) des Triacs (7) gesendet wird.

4. Steuereinheit (1) nach Anspruch 3, **gekennzeichnet durch** einen optischen Isolator (2), der **durch** einen Widerstand (R3) angetrieben wird, der in der Rückkopplungsleitung (8) angeordnet ist.

5. Steuereinheit (1) nach einem der vorangehenden Ansprüche, **dadurch gekennzeichnet, dass** der Mikroprozessor (4), dafür sorgt, dass das Triac (7) solange aktiviert wird, wie das im Haushaltsgerät umgesetzte Programm andauert, und dafür sorgt, dass die Signale zum Aktivieren des Triacs (7) zu einem bestimmten Zeitpunkt nach Ende des im Haushaltsgerät umgesetzten Programms unterbrochen werden, und das Haushaltsgerät nach einem bestimmten Zeitraum, der in seiner Software vorgegeben ist, in den Ausschaltmodus umschaltet.

6. Steuereinheit (1) nach Anspruch 5, **dadurch gekennzeichnet, dass** der Mikroprozessor (4) dafür sorgt, dass der Benutzer durch ein Summer- und/oder ein LED-Warnsystem informiert wird, wenn das im Haushaltsgerät umgesetzte Programm endet, und bevor das Haushaltsgerät in den Ausschaltmodus umgeschaltet wird.

7. Waschmaschine, **gekennzeichnet durch** eine Steuereinheit (1) nach einem der vorangehenden Ansprüche.

8. Wäschetrockner, **gekennzeichnet durch** eine Steuereinheit (1) nach einem der Ansprüche 1 bis 6.

9. Geschirrspüler, **gekennzeichnet durch** eine Steuereinheit (1) nach einem der Ansprüche 1 bis 6.

10. Kochvorrichtung, **gekennzeichnet durch** eine Steuereinheit (1) nach einem der Ansprüche 1 bis 6.

## Revendications

1. Une unité de commande (1) adaptée pour être utilisée dans un électroménager, comprenant une unité de source d'alimentation (3) qui est reliée à la ligne d'alimentation (L1, L2), qui fournit le courant alternatif électrique reçu du réseau et qui permet l'alimentation des éléments électroniques, un microprocesseur (4) qui est alimenté par le courant à basse tension généré par l'unité de source d'alimentation (3), une ligne de commutation (5) qui commande le courant en milliampères traversant celle-ci pour la fonction de commutation, un bouton (6) qui commute le courant à basse valeur traversant la ligne de commutation (5), qui permet à la ligne de commutation (5) d'alimenter le courant électrique et de changer l'électroménager au mode de marche lorsqu'il est poussé par l'utilisateur et qui permet au courant traversant la ligne de commutation (5) d'être coupé alors que le mode de marche de l'électroménager continue lorsque l'utilisateur lève sa main,
comprenant en outre
- un triac (7) qui est relié à la ligne d'alimentation (L1, L2) par l'intermédiaire de ses bornes principales (A1, A2) et qui commande et transmet le courant électrique reçu du réseau à l'unité de source d'alimentation (3),
- la ligne de commutation (5) dont une extrémité est reliée à la ligne d'alimentation (L1, L2), l'autre extrémité est relié à la borne grille (G) du triac (7), qui actionne le triac (7) lorsque le bouton (6) est poussé par l'utilisateur, en transmettant le courant électrique et permettant au triac (7) d'alimenter l'unité de source d'alimentation (3), et
**caractérisée par**
- une ligne de retour (8) qui transmet les signaux de retour transmis par le microprocesseur (4), qui est alimenté par l'unité de source d'alimentation (3), à la borne grille (G) du triac (7) et qui continue à actionner le triac (7) lorsque les signaux d'actionnement transmis au triac (7) par la ligne de commutation (5) sont coupés par l'utilisateur levant sa main du bouton (6).

2. Une unité de commande (1) selon la Revendication 1, **caractérisée par** la ligne de commutation (5) présentant une ou plus d'une résistance (R1, R2) sur celle-ci qui tombe le courant de secteur à la valeur de courant nécessaire pour actionner le triac (7).

3. Une unité de commande (1), selon la Revendication 1 ou 2, **caractérisée par** un optocoupleur (2) qui est disposé dans la ligne de retour (8) et qui permet au signal de retour transmis par le microprocesseur (4) d'être transmis à la borne grille (G) du triac (7).

4. Une unité de commande (1) selon la Revendication 3, **caractérisée par** un optocoupleur (2) qui est entraîné à travers une résistance (R3) disposée sur la ligne de retour (8).

5. Une unité de commande (1) selon l'une quelconque des revendications précédentes, **caractérisée par** le microprocesseur (4) qui permet au triac (7) d'être actionné en tant que le programme mis en oeuvre dans l'électroménager continue, donc permettant aux signaux, qui actionnent le triac (7), d'être coupés un certain temps après que le programme mis en oeuvre dans l'électroménager se termine et changeant l'électroménager en mode arrêt après un certain temps prédéfinie dans son logiciel.

6. Une unité de commande (1) selon la Revendication 5, **caractérisée par** le microprocesseur (4) qui permet à l'utilisateur d'être averti par des systèmes d'avertissement sonores et/ou LED lorsque le programme mis en oeuvre dans l'électroménager se termine et avant que l'électroménager est changé en mode arrêt.

7. Un lave-linge **caractérisé par** une unité de commande (1) selon l'une quelconque des revendications précédentes.

8. Un sèche-linge **caractérisé par** une unité de commande (1) selon l'une quelconque des revendications de 1 à 6.

9. Un lave-vaisselle **caractérisé par** une unité de commande (1) selon l'une quelconque des revendications de 1 à 6.

10. Un dispositif de cuisson **caractérisé par** une unité de commande (1) selon l'une quelconque des revendications de 1 à 6.
